# EUROPÄISCHE PATENTANMELDUNG

(11) **EP 2 918 351 A1**
(43) Veröffentlichungstag der Anmeldung: **16.09.2015**
(21) Anmeldenummer: 15158653.4
(22) Anmeldetag: 11.03.2015
(51) Int. Cl.: B08B 7/00, G01R 31/319, G01R 1/04, G01R 1/073

(54) **Vorrichtung zum Prüfen von elektronischen Bauteilen**

(30) Priorität: 11.03.2014 DE 102014103262
(71) Anmelder: Multitest elektronische Systeme GmbH, 83026 Rosenheim (DE)
(72) Erfinder: Leikermoser, Volker, 83229 Aschau (DE); Gschwendtberger, Gerhard, 83098 Brannenburg (DE)
(74) Vertreter: Dilg, Haeusler, Schindelmann Patentanwaltsgesellschaft mbH

(57) **Zusammenfassung**

Die Erfindung geht aus von einer Vorrichtung zum Prüfen von elektronischen Bauteilen (4) mit wenigstens einem Prüfsockel (1) mit Prüfkontakten (2), mit einem einem Nest (3), in dem wenigstens ein elektronisches Bauteil (4) platzierbar ist und mit wenigstens einer Reinigungseinheit (6, 7; 8, 9; 10, 7, 9) für die Prüfkontakte (2) des Prüfsockels (1), wobei das elektronische Bauteil (4) durch eine als Prüfhub ausführbare Relativbewegung zwischen Prüfsockel (1) und Nest (3) an die Prüfkontakte (2) des Prüfsockels (1) andrückbar und wieder von diesen abhebbar ist. Erfindungsgemäß ist die wenigstens eine Reinigungseinheit (6, 7; 8, 9; 10, 7, 9) so ausgestaltet, dass die Prüfkontakte (2) bei jedem Prüfhub mit der wenigstens einen Reinigungseinheit (6, 7; 8, 9; 10, 7, 9) in Kontakt kommen.

## Beschreibung

Die Erfindung betrifft eine Vorrichtung zum Prüfen von elektronischen Bauteilen nach dem Oberbegriff von Anspruch 1,

Elektronische Bauteile werden üblicherweise nach ihrer Herstellung bestimmten Tests unterzogen, um ihre elektrischen Funktionen zu überprüfen. Hierzu ist üblicherweise ein Nest auf einem auf- und abfahrbaren Stempel befestigt, in dem das elektronische Bauteil exakt positioniert wird. Es ist aber auch bekannt, mehrere elektronische Bauteile auf einem Träger zu befestigen und den gesamten Träger in dem Nest zu positionieren.

Stempel und Nest gehören zu einer Handhabungsvorrichtung, dem so genannten Handler. An dem Handler ist üblicherweise ein Test-Kopf befestigt, mit dem die eingehenden Signale ausgewertet werden und eine Entscheidung über die Qualität der geprüften elektronischen Bauteile getroffen wird. Die elektronischen Bauteile werden einzeln mit einem Prüfsockel oder - bei Verwendung eines Trägers - in Gruppen mit einem oder mehreren Prüfsockeln gleichzeitig kontaktiert. Dabei werden die Kontakte der elektronischen Bauteile mit vorbestimmter Kraft an die Prüfkontakte des oder der Prüfsockel angepresst.

Es hat sich herausgestellt, dass die Prüfkontakte der Prüfsockel mit der Zeit verschmutzen, z. B. durch die Ablagerung von Zinn und dessen Oxidation, wobei die Leitfähigkeit abnimmt und eine aussagefähige Prüfung der elektronischen Bauteile immer schwieriger wird. Die Prüfkontakte müssen deshalb in relativ kurzen Zeitabständen gereinigt oder ausgetauscht werden.

Zu diesem Zweck muss die Prüfung unterbrochen und die Prüfsockel müssen ausgebaut und oftmals sogar demontiert werden. Nach der Reinigung oder dem Austausch der Prüfkontakte erfolgt der Zusammenbau und die Wiederinbetriebnahme der Prüfeinrichtung in umgekehrter Reihenfolge.

Es wurde auch bereits versucht, eine Reinigungseinrichtung vorzusehen, die nach der Prüfung einer vorherbestimmten Anzahl von Prüfvorgängen die Prüfung automatisch unterbricht, in den Bereich des Prüfsockels verfährt und die Prüfkontakte mechanisch, beispielsweise mit Hilfe von Bürsten, reinigt. Aber auch bei diesem Verfahren muss die eigentliche Prüfung der elektronischen Bauteile unterbrochen werden, so dass sich die durchschnittliche Zykluszeit verlängert.

Es wurden auch bereits so genannte Reinigungs Dummys verwendet. Diese Reinigungs Dummys besitzen die gleiche Form wie die zu prüfenden elektronischen Bauteile. Anstatt der Kontakte sind jedoch Teile mit Reinigungsfunktion vorgesehen. Aufgrund der geringen Relativbewegung zwischen den Teilen mit Reinigungsfunktion und den Prüfkontakten der Prüfsockel ist auch die Reinigungswirkung eher als gering einzustufen. Es müssen deshalb sehr oft solche Reinigungs Dummys in die Prüfung eingeschleust werden um eine Verschlechterung des Prüfergebnisses zu verhindern. Ebenso besteht kaum die Möglichkeit, ältere Handler nachzurüsten, da diese älteren Geräte nicht dazu in der Lage sind, die Reinigungsw Dummys von zu prüfenden elektronischen Bausteinen zu unterscheiden. Auch bei dieser Vorgehensweise verlängert sich die durchschnittliche Zykluszeit.

US 2011/ 0 132 396 A1 offenbart ein Reinigungsmaterial zum Reinigen von Kontaktelementen und Trägerstrukturen von Testschnittstellen, wie beispielsweise Prüfsockel, welche für Funktionstests von Halbleiterbauteilen verwendet wird. Das Reinigungsmaterial weist eine Reinigungsschicht auf, unter welcher mehrere Zwischenschichten, welche die Reinigungsschicht stützen, angeordnet sind. Mit dem Reinigungsmaterial können Verschmutzungen von den Kontaktelementen und den Trägerstrukturen entfernt werden.

DE 10 2008 029 129 A1 offenbart eine Kontaktiervorrichtung zum Kontaktieren von elektronischen Bauelementen, insbesondere ICs, mit Kontaktfedern eines Kontaktsockels. Eine Bandreinigungseinrichtung mit einem Bandbewegungsmechanismus und einem Reinigungsband ist vorgesehen, das über die Kontaktfedern des Kontaktsockels geführt ist. Das Reinigungsband weist mindestens eine Aussparung, durch die ein Bauelement hindurchführbar ist, und mindestens einen Reinigungsbereich auf, der auf seiner den Kontaktfedern zugewandten Seite mit einer Klebeschicht versehen ist.

US 2007/ 0 205 753 A1 offenbart ein Verfahren zum Reinigen von Kontaktpins einer automatischen Testvorrichtung, wobei eine Ersatzreinigungsvorrichtung in einen Testsockel eingebracht wird, um die Kontaktpins mit einem Reinigungsmittel zu reinigen.

Der Erfindung liegt die Aufgabe zugrunde, eine Vorrichtung zum Prüfen von elektronischen Bauteilen nach dem Oberbegriff von Anspruch 1 zu schaffen, die die Nachteile der bekannten Vorrichtungen minimiert oder ganz vermeidet.

Gelöst wird die Aufgabe gemäß der Erfindung durch eine Vorrichtung zum Prüfen von elektronischen Bauteilen mit den Merkmalen von Anspruch 1. Dadurch, dass die wenigstens eine Reinigungseinheit so ausgestaltet ist, dass die Prüfkontakte bei jedem Prüfhub mit der wenigstens einen Reinigungseinheit in Kontakt kommen, werden die Prüfkontakte vor und/oder nach jeder Prüfung gereinigt, so dass sich keine größeren Ablagerungen auf den Prüfkontakten bilden können. Weiterhin ist zur Reinigung keine Unterbrechung der Prüfung notwendig. Da die Reinigung praktisch während des Prüfhubs vollzogen wird, muss keine zusätzliche Zeit für die Reinigung eingeplant werden, so dass sich die durchschnittliche Zykluszeit nicht verlängert.

Für die Reinigung müssen keine aggressiven Reinigungsmittel eingesetzt werden, da die Reinigung bei jedem Prüfhub erfolgt. Es müssen folglich jeweils nur sehr geringe Verschmutzungen entfernt werden. Weiterhin besteht nicht die Gefahr, dass sich Ablagerungen durch Trocknung oder Oxidation verfestigen, da Ablagerungen die von einem elektronischen Bauteil evtl. auf die Prüfkontakte übertragen werden, bereits vor der Prüfung des nächsten elektronischen Bauteils wieder entfernt werden.

Weitere Einzelheiten und Vorteile der Erfindung ergeben sich aus den Unteransprüchen.

Bei einer Ausführungsform der Erfindung ist die wenigstens eine Reinigungseinheit so montiert, dass sie sich zusammen mit dem Nest bewegt. Dadurch nimmt die Reinigungseinheit an jeder Bewegung des Nests teil. Es ist folglich sichergestellt, dass immer dann, wenn das Nest in Prüfposition verfährt, ein Reinigungsvorgang durchgeführt wird. Es wird aber noch ein zweiter Reinigungsvorgang durchgeführt, wenn das Nest in eine Position zurück gefahren wird, in der das bereits geprüfte elektronische Bauteil durch ein noch ungeprüftes elektronisches Bauteil ersetzt wird. Das bedeutet, dass pro Prüfzyklus zwei Reinigungsvorgänge durchgeführt werden, nämlich ein Reinigungsvorgang vor der Prüfung, wenn das Nest in Prüfposition gebracht wird, und ein Reinigungsvorgang nach der Prüfung, wenn das Nest wieder zurück gefahren wird.

In einem ersten Ausführungsbeispiel ist die wenigstens eine Reinigungseinheit an dem Nest oder an einem das Nest bewegendem Stempel montiert. Bei diesem Ausführungsbeispiel hängt die Anzahl der notwendigen Reinigungseinheiten von der Lage der Kontakte der elektronischen Bauteile ab. Sind die Kontakte beispielsweise auf zwei gegenüber liegenden Seiten des elektronischen Bauteils angeordnet, so werden ebenfalls zwei Reinigungseinheiten verwendet. Sind die Kontakte aber über alle vier Seiten des elektronischen Bauteils verteilt, so können auch vier Reinigungseinheiten notwendig sein, da auch die Prüfkontakte des Prüfsockels entsprechend angeordnet sind. Bei einseitig angeordneten Kontakten des elektronischen Bauteils und entsprechend angeordneten Prüfkontakten des Prüfsockels ist eine Reinigungseinheit ausreichend.

Um zu prüfende elektronische Bauteile positionsgenau in dem Nest zu fixieren, werden oftmals spezielle Halteglieder verwendet. Diese Halteglieder werden meist über einen Rastmechanismus mit dem Nest gekoppelt, so dass sich das zu prüfende elektronische Bauteil zwischen Nest und Halteglied befindet. Bei einem zweiten Ausführungsbeispiel der Erfindung, bei dem das elektronische Bauteil durch ein Halteglied in dem Nest fixiert ist, ist es möglich, die wenigstens eine Reinigungseinheit an dem Halteglied zu befestigen. Selbstverständlich ist es auch möglich, die Reinigungsfunktion direkt in das Halteglied zu integrieren.

Bei einer weiteren Ausführungsform ist die wenigstens eine Reinigungseineinheit beweglich an dem Prüfsockel befestigt. Bei dieser Ausführungsform nimmt die Reinigungseinheit nicht an der gesamten Bewegung des Nests teil, sondern benutzt das Nest nur als Antrieb für eine Bewegung, die nur so weit führen muss, dass die Reinigungseinheit ihre Reinigungsfunktion wahrnehmen kann.

Es besteht die Möglichkeit, die Reinigungseinheit z. B. magnetisch oder mechanisch an die Bewegung des Nests zu koppeln und die Kopplung bei der Rückwärtsbewegung des Nests wieder aufzuheben. Besonders vorteilhaft ist die wenigstens eine Reinigungseinheit jedoch entgegen der Kraft eines elastischen Elements gegen den Prüfsockel beweglich. Auf diese Weise ist keine Kopplung notwendig, da bei nachlassendem Anpressdruck während der Rückbewegung des Nests die Reinigungseineinheit von dem elastischen Element in seine Ausgangslage zurückgedrückt wird.

Dabei kann die wenigstens eine Reinigungseinheit durch das Nest selbst oder durch mit dem Nest gekoppelte Teile bewegt werden. Ein solches mit dem Nest gekoppeltes Teil kann beispielsweise das zu prüfende elektronische Bauteil selbst sein. Um Beschädigungen des elektronischen Bauteils zu vermeiden, wird jedoch für diesen Zweck vorteilhaft ein Halteglied, oder aber ein extra an dem Nest vorgesehener Schubstößel verwendet.

Auch bei dieser Ausführungsform werden pro Prüfzyklus zwei Reinigungsvorgänge durchgeführt, so dass es bei allen Varianten zu einer intensiven Reinigung der Prüfkontakte kommt und eine Ablagerung von unerwünschten Partikeln sicher vermieden werden kann.

Vorteilhaft weist die wenigstens eine Reinigungseinheit einen Grundkörper und wenigstens ein Kontaktmodul auf. Je nach Ausführungsbeispiel können mehrere Reinigungseinheiten mit jeweils nur einem Kontaktmodul, oder aber auch nur eine Reinigungseinheit mit mehreren Kontaktmodulen vorgesehen sein.

Die Kontaktmodule können sehr unterschiedlich ausgestaltet sein. Es hat sich als vorteilhaft erwiesen, wenn das wenigstens eine Kontaktmodul Borsten aufweist. Die Borsten können so ausgewählt werden, dass sie eine gute Reinigungswirkung erzielen, ohne die Prüfkontakte abzunutzen oder zu beschädigen. Die gewünschten Eigenschaften lassen sich über die Oberfläche, die Länge, die Stärke und die Elastizität der Borsten einstellen.

Es ist jedoch auch möglich, das Kontaktmodul aus einem anderen Werkstoff zu fertigen. Es hat sich ebenfalls bewährt, wenn das wenigstens eine Kontaktmodul aus einem elastischen Kunststoff besteht, wobei eine die Prüfkontakte reinigende Oberfläche des wenigstens einen Kontaktmoduls eine vorbestimmte Rauigkeit aufweist. Derartige Kontaktmodule lassen sich beispielsweise sehr kostengünstig aus einem Schaumstoff fertigen, wobei auch hier die gewünschten Eigenschaften sehr einfach über das Grundmaterial und das Raumgewicht des Schaumstoffs eingestellt werden können.

Das wenigstens eine Kontaktmodul weist vorteilhafterweise eine Härte auf, die eine konstante Reinigung der Prüfkontakte des Prüfsockels gewährleistet ohne dabei die Prüfkontakte zu beschädigen. Das bedeutet aber, dass die Kontaktmodule vorteilhafterweise weicher als die Prüfkontakte ausgeführt sind und sich deshalb abnutzen. Um die ständige Reinigung der Prüfkontakte sicherstellen zu können, ist die wenigstens eine Reinigungseineinheit bei einer Ausführungsform deshalb auswechselbar.

Bei einer weiteren Ausführungsform ist aus den gleichen Gründen nur das wenigstens eine Kontaktmodul auswechselbar. Es ist im jeweiligen Fall die Investitionskosten gegenüber dem Arbeitsaufwand für den Austausch abzuwägen.

Weitere Einzelheiten und Vorteile der Erfindung ergeben sich aus der Beschreibung von Ausführungsbeispielen, die anhand der Zeichnung eingehend erläutert werden.

Es zeigen:
- Fig. 1a und 1b: eine schematische Teilansicht eines ersten Ausführungsbeispiels der Erfindung in verschiedenen Stellungen,
- Fig. 2a und 2b: eine entsprechende Teilansicht eines zweiten Ausführungsbeispiels in den selben Stellungen,
- Fig. 3a und 3b: eine Ansicht eines dritten Ausführungsbeispiels
- Fig. 4a und 4b: ein Detail eines weiteren Ausführungsbeispiels und
- Fig. 5: eine grob schematische Darstellung eines Handlers für Einzelprüfungen.

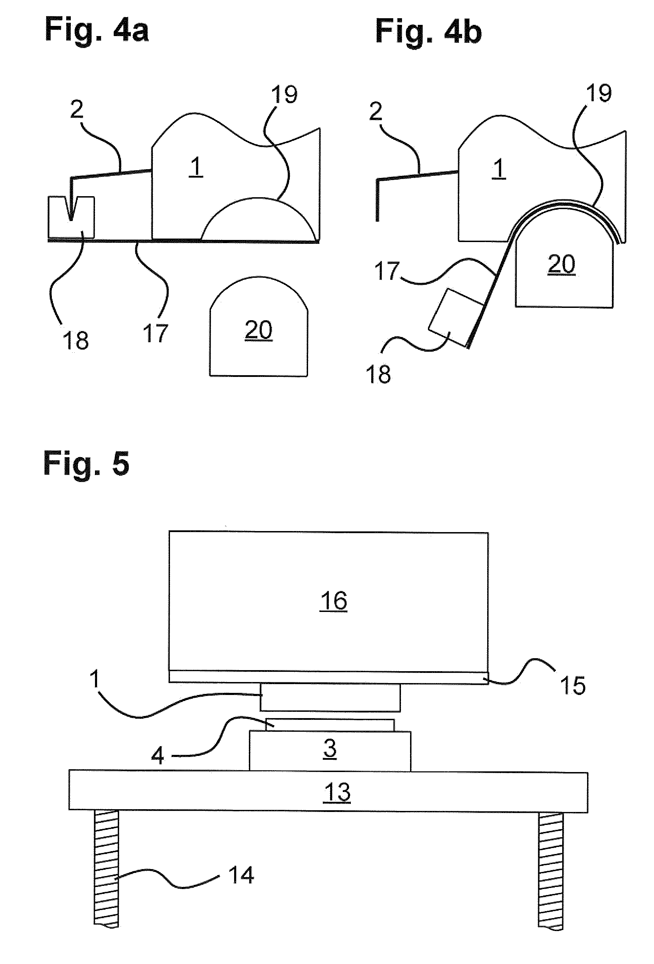

Der Handler nach Fig. 5 weist einen Druckstempel 13 auf, der mit Hilfe der Gewindestangen 14 gleichmäßig nach oben und unten bewegt werden kann. Auf dem Druckstempel 13 ist das Nest 3 vorgesehen, welches die Aufnahme für das zu prüfende elektronische Bauteil 4 bildet. Es kann aber auch ein Träger vorgesehen sein, der über eine X-Y-Verschiebeeinrichtung positionierbar ist und mit einer größeren Anzahl zu prüfender elektronischer Bauteile bestückt ist.

Mit dem Bezugszeichen 1 ist ein Prüfsockel oder ein Prüfsockel-Array bezeichnet. Mit einem Prüfsockel-Array lassen sich mehrere elektronische Bauteile gleichzeitig prüfen. Da es bei der vorliegenden Erfindung jedoch keine Rolle spielt, ob jeweils nur ein elektronisches Bauteil oder mehrere elektronische Bauteile gleichzeitig geprüft werden, soll die erfindungsgemäße Vorrichtung anhand einer Einzelprüfung erläutert werden.

Das Nest 3 ist auf dem Druckstempel 13 so positioniert, dass sich das darin befindliche elektronische Bauteil 4 mit seinen Kontakten exakt unter den Prüfkontakten des Prüfsockels 1 befindet. Über dem Druckstempel 13 und dem Nest 3 ist der Testkopf 16 als festes, unbewegliches Modul montiert. Die Verbindung zwischen dem Testkopf 16 und dem Prüfsockel 1 wird durch das Loadboard 15 geschaffen.

Zum Prüfen des elektronischen Bauteils 4 wird der Druckstempel 13 nach oben gefahren und die Kontakte des elektronischen Bauteils werden mit großer Kraft gegen die Prüfkontakte des Prüfsockels 1 gedrückt. Der Anpressdruck ist vorteilhafterweise dabei so groß, dass zwischen den Kontakten des elektronischen Bauteils 4 und den hier nicht dargestellten Prüfkontakten des Prüfsockels 1 eine leitende Verbindung sichergestellt werden kann. Erst dann erfolgt die Prüfung nach einem vorbestimmten Programm.

Nach der Prüfung wird der Druckstempel 13 wieder abgesenkt, so dass sich die Kontakte des elektronischen Bauteils von den Prüfkontakten des Prüfsockels 1 lösen. In unterster Stellung kann nun das bereits geprüfte elektronische Bauteil beispielsweise durch ein so genanntes Pick-and-Place-Device entnommen und gegen ein noch zu prüfendes elektronisches Bauteil ausgetauscht werden.

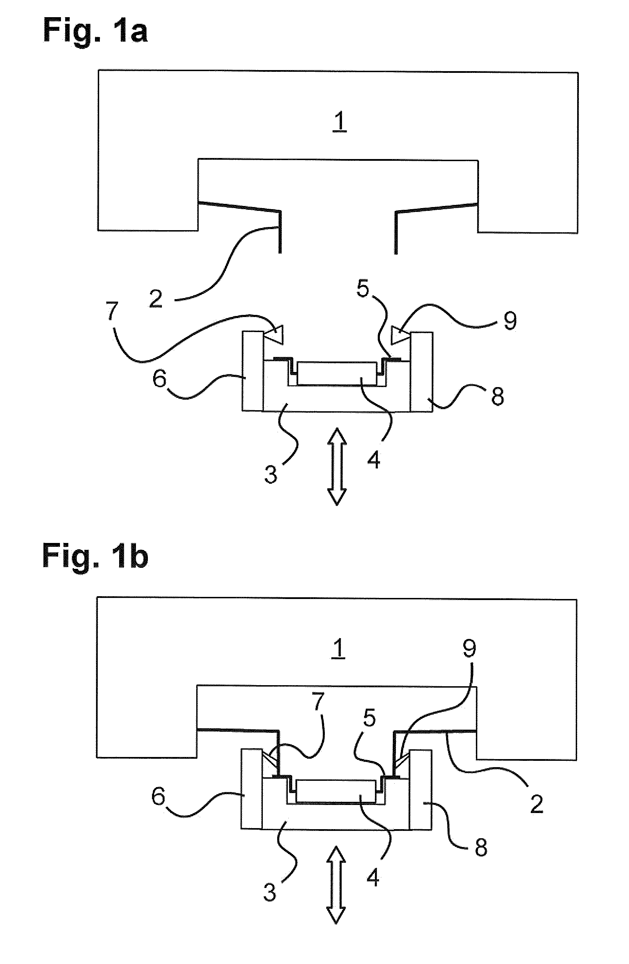

In allen drei Ausführungsbeispielen nach den Figuren 1 bis 3 sind der Prüfsockel 1 mit den Prüfkontakten 2, das Nest 3 und das zu prüfende elektronische Bauteil 4 mit den Kontakten 5 in gleicher Weise dargestellt. Gleiche Teile sind in allen Figuren mit gleichen Bezugszeichen versehen. Der Druckstempel 13 ist in den Figuren 1 bis 3 nicht dargestellt, wird aber durch den Doppelpfeil unterhalb des Nests 3 symbolisiert.

Der Prüfsockel 1 weist auf zwei gegenüberliegenden Seiten Prüfkontakte 2 auf. Die Prüfkontakte sind hier als Kontaktfedern gezeigt, deren Spitzen sich gegen den Prüfsockel 1 drücken lassen. Der Winkel, mit dem die Kontaktfedern an dem Prüfsockel befestigt sind, weicht nur geringfügig von einem 90°-Winkel ab. Auf diese Weise hat ein Nachgeben der Spitze der Prüfkontakte nur einen sehr geringen Versatz der Prüfspitze in der horizontalen Ebene zur Folge. Die Zuordnung zwischen den Spitzen der Prüfkontakte 2 und den Kontakten 5 des zu prüfenden Bauteils 4 bleibt folglich auch während des Einfederns der Prüfkontakte 2 erhalten.

Die Erfindung wird hier anhand eines Prüfsockels mit Prüfkontakten erläutert, die als Kontaktfedern ausgebildet sind. Die Erfindung kann jedoch auch bei Prüfsockeln verwendet werden, deren Prüfkontakte als federbelastete Prüf-Pins ausgebildet sind.

In dem Ausführungsbeispiel nach Fig. 1a und Fig. 1b ist an zwei gegenüberliegenden Seiten des Nests 3 jeweils eine Reinigungseineinheit 6, 7 und 8, 9 befestigt. Jede Reinigungseinheit weist hier einen Grundkörper 6, 8 und ein Kontaktmodul 7, 9 auf. Beide Reinigungseinheiten sind vorteilhaft mit dem Nest 3 verschraubt oder über eine lösbare Rastverbindung an dem Nest 3 fixiert. Die Kontaktmodule 7, 9 sind pinselartig mit Borsten ausgeführt. Die Borsten sind so gewählt, dass frische Ablagerungen auf den Prüfkontakten 2 entfernt werden können, dass aber auch eine sehr große Anzahl von Prüfhüben die Prüfkontakte 2 nicht schädigt.

Da bei dem Kontakt während einer Relativbewegung zwischen Prüfkontakten 2 und Kontaktmodulen 7, 9 die Prüfkontakte 2 nicht verschleißen dürfen, werden sich die Kontaktmodule 7, 9 im Laufe der Zeit verbrauchen. Die Kontaktmodule müssen deshalb von Zeit zu Zeit erneuert werden. Es besteht grundsätzlich die Möglichkeit entweder nur die Kontaktmodule 7, 9 oder die ganzen Reinigungseinheiten zusammen mit den Grundkörpern 6, 8 auszutauschen. Welche der beiden Möglichkeiten die kostengünstigere ist, wird sich beispielsweise daran orientieren, was für ein Kontaktmodul verwendet wird.

Zu Beginn eines Prüfhubs fährt das Nest 3 nach oben gegen den Prüfsockel 1. Während dieser Bewegung kommen die Prüfkontakte 2 mit den Kontaktmodulen 7, 9 in Berührung, drücken diese etwas nach unten und verformen die Kontaktmodule 7, 9 dabei elastisch. Bei der weiteren Bewegung bis in die Prüfstellung (siehe Fig. 1b) streifen die elastisch verformten Kontaktmodule 7, 9 an den Prüfkontakten 2 entlang. Dabei werden Ablagerungen wie Schmutz- oder Zinnteilchen von den Prüfkontakten entfernt. In der Prüfstellung befindet sich der an dem Prüfsockel 1 befestigte Schenkel der Prüfkontakte 2 praktisch in einer horizontalen Ausrichtung.

Nach der Prüfung können sich wiederum Ablagerungen an den Prüfkontakten 2 befinden. Die Kontaktmodule 7, 9 werden deshalb bei der Abwärtsbewegung des Nests 3 in die andere Richtung elastisch verformt und streichen erneut an den Prüfkontakten entlang, um auch diese Ablagerungen sofort wieder zu entfernen.

Die Prüfkontakte werden folglich bei jedem Prüfhub zweimal gereinigt, einmal bei der Aufwärts- und einmal bei der Abwärtsbewegung des Nests 3. Die Reinigung erfolgt dabei während des normalen Prüfhubs, so dass keinerlei zusätzliche Bewegungen erforderlich sind. Auf diese Weise muss auch keine Verlängerung des durchschnittlichen Prüfzyklus in Kauf genommen werden. Die Reinigung der Prüfkontakte erfolgt also ohne jeglichen Zeitverlust.

Durch die Reinigung bleibt die Leitfähigkeit zwischen den Prüfkontakten 2 des Prüfsockels 1 und den Kontakten 5 des zu prüfenden elektronischen Bauteils 4 während der Prüfung wesentlich länger erhalten. Das führt dazu, dass die Prüfkontakte 2 seltener ausgetauscht werden müssen. Letztendlich führt die erfindungsgemäße Anordnung folglich sogar zu einer Verkürzung der durchschnittlichen Zykluszeit.

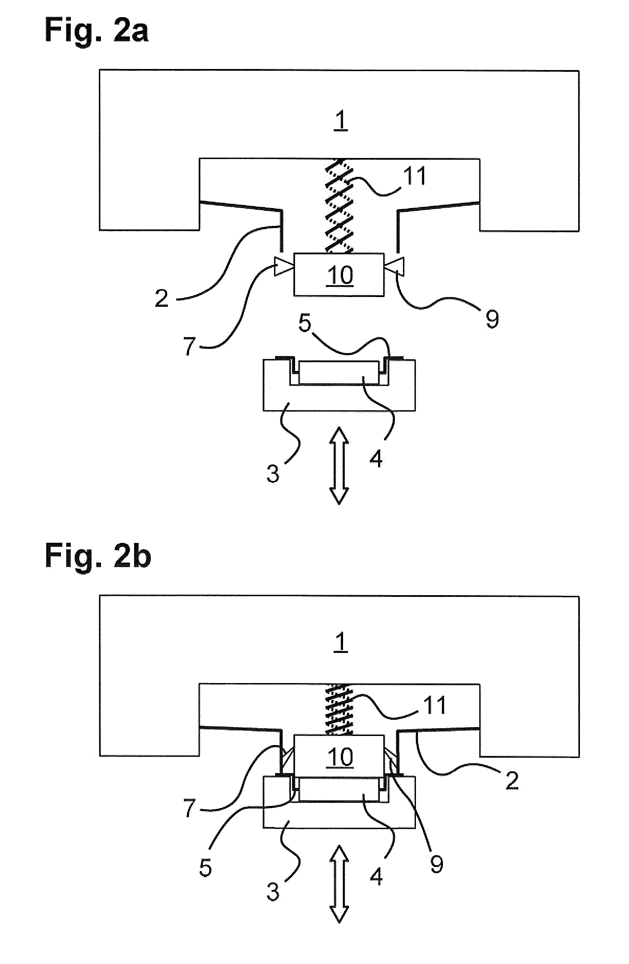

In dem Ausführungsbeispiel nach Fig. 2a und Fig. 2b ist nur eine Reinigungseinheit vorgesehen, die ganz anders als in dem Ausführungsbeispiel nach Fig. 1 montiert ist. Ein einteiliger Grundkörper 10 der mit zwei Kontaktmodulen 7, 9 ausgestattet ist, ist mit Hilfe eines Federelements 11 direkt an dem Prüfsockel 1 befestigt. Die Reinigungseinheit ist so positioniert, dass sich die Kontaktmodule 7, 9 in der Ruhelage der Reinigungseinheit unterhalb der Spitzen der Prüfkontakte 2 befinden.

Eine Führung der Reinigungseinheit kann entweder über das Federelement 1 gegeben sein, oder es ist eine eigene Führung an dem Prüfsockel 1 vorgesehen, die gewährleistet, dass sich die Reinigungseinheit nur in Richtung des Doppelpfeils bewegt und nicht seitlich ausbrechen kann.

Bei der Aufwärtsbewegung des Nests 3 zu Beginn des Prüfhubs nimmt die Reinigungseinheit nicht an der Bewegung des Nests 3 teil. Erst wenn das zu prüfende elektronische Bauteil 4 (siehe Fig. 2b) die Unterseite des einteiligen Grundkörpers 10 berührt, wird bei der weiteren Bewegung des Nests 3 in die Prüfposition die Reinigungseinheit an der Bewegung beteiligt. In Fig. 2 ist der Einfachheit halber das zu prüfende elektronische Bauteil 4 selbst als Mitnehmer für die Reinigungseinheit dargestellt. Vorteilhaft ist jedoch an dem Nest ein Mitnehmer vorgesehen, über den die Reinigungseinheit bewegt wird, ohne dass das elektronische Bauteil 4 als Schieber missbraucht werden muss.

Die Reinigungseinheit mit dem einteiligen Grundkörper 10 und den beiden Kontaktmodulen 7 und 9 wird bei diesem Ausführungsbeispiel nur über eine sehr geringe Distanz bewegt. Die Bewegung reicht aber dazu aus, dass die beiden Kontaktmodule 7 und 9 mit den Prüfkontakten in Berührung kommen und an diesen entlang streichen.

Gegenüber dem Ausführungsbeispiel nach Fig. 1 bewegt sich die Reinigungseinheit aber nur über eine Strecke, die für die Reinigung der Prüfkontakte 2 notwendig ist. An der Bewegung über die restliche Strecke, über die das Nest 3 bewegt wird, nimmt die Reinigungseinheit nicht teil.

Die Reinigungswirkung ist jedoch die gleiche wie bei dem Ausführungsbeispiel nach Fig. 1. Auch hier werden die Prüfkontakte 2 zweimal, nämlich vor und nach jeder Prüfung gereinigt. Ebenso sollte vorteilhafterweise die Austauschbarkeit gewährleistet sein. Es können deshalb wiederum entweder die beiden Kontaktmodule 7, 9 oder die komplette Reinigungseinheit mit dem einteiligen Grundkörper 10 und den beiden Kontaktmodulen 7 und 9 ausgewechselt werden.

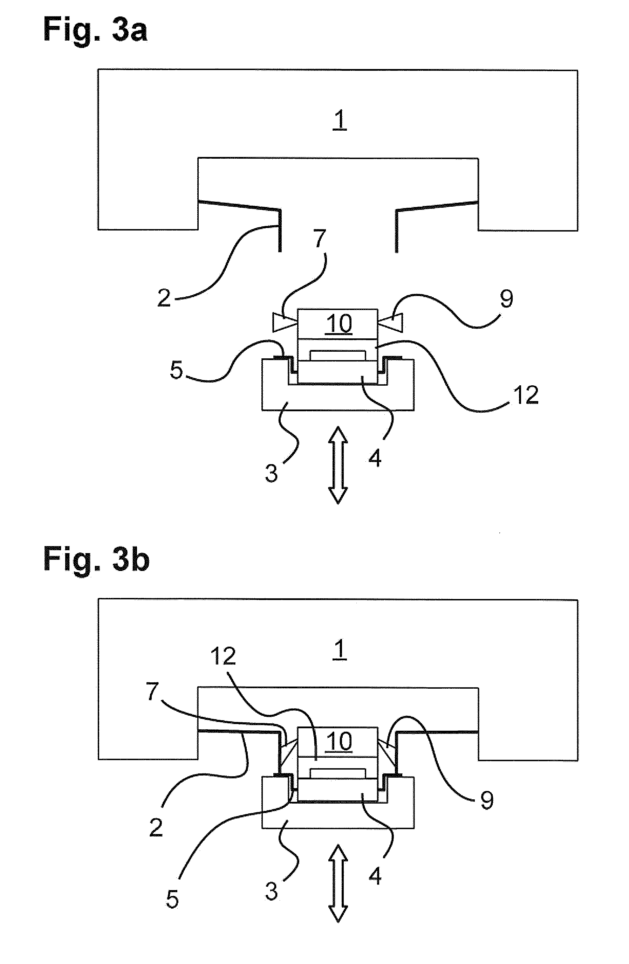

Ein weiteres Ausführungsbeispiel ist in Fig. 3a und Fig. 3b gezeigt. Hier ist ein Halteglied 12 vorgesehen, das unter anderem die Aufgabe hat, das zu prüfende elektronische Bauteil 4 in dem Nest 3 zu fixieren. Auch bei einer waagrechten Ausrichtung der Anordnung ist es damit möglich, das elektronische Bauteil sicher zu führen und in dem Nest zu halten.

Das Ausführungsbeispiel in Fig. 3 zeigt wiederum eine Reinigungseinheit mit einem einteiligen Grundkörper 10 und zwei damit verbundenen Kontaktmodulen 7 und 9. Die Reinigungseinheit ist hier an dem Halteglied 12 befestigt. Sie kann aber auch einteilig mit dem Halteglied 12 ausgeführt sein, so dass bei entsprechender Abnutzung der Kontaktmodule 7, 9 einfach das gesamte Halteglied 12 zu tauschen ist. Andererseits soll es aber auch bei diesem Ausführungsbeispiel Formen geben, bei denen entweder der Grundkörper 10 mit den beiden Kontaktmodulen oder nur die Kontaktmodule 7, 9 erneuert werden können.

Da auch bei diesem Ausführungsbeispiel die Bewegung der Reinigungseinheit an die Bewegung des Nests 3 gekoppelt ist, läuft der eigentliche Reinigungsvorgang der Prüfkontakte 2 in gleicher Weise wie bei dem Ausführungsbeispiel nach Fig. 1 ab. Auch hier wird der einteilige Grundkörper 10 mit den Kontaktmodulen 7, 9 sofort bei Beginn des Prüfhubs zusammen mit dem Nest 3 nach oben bewegt.

Sowohl vor der eigentlichen Prüfung des elektronischen Bausteins 4, wie auch nach der Prüfung stehen die Kontaktmodule 7, 9 mit den Prüfkontakten 2 des Prüfsockels 1 in Verbindung und streifen während der Relativbewegung der beiden Komponenten zueinander an den Prüfkontakten anhaftende Ablagerungen ab. Also finden auch hier wieder pro Prüfung zwei Reinigungsvorgänge der Spitzen der Prüfkontakte 2 statt.

Die Erfindung ist auch bei Vorrichtungen anwendbar, bei denen anstatt des Nests der Prüfsockel bewegt wird. Da es nur auf die Relativbewegung zwischen dem Nest mit dem darin befindlichen elektronischen Bauteil und dem Prüfsockel mit den Prüfkontakten ankommt, findet auch bei solch einer Vorrichtung eine effektive Reinigung mit zwei Reinigungsvorgängen bei jedem Prüfhub statt.

In Fig. 4a und Fig. 4b ist ein Ausführungsbeispiel gezeigt, bei dem die Reinigungseinheit wie bei dem Ausführungsbeispiel nach Fig. 2 an dem Prüfsockel 1 befestigt ist, aber durch das Nest 3 oder mit dessen Bewegung gekoppelte Teile bewegt wird. Statt den in den anderen Ausführungsbeispielen verwendeten Borsten ist hier für die Reinigung der Prüfkontakte 2 jeweils ein Elastomer-Pad 18 vorgesehen. Das verwendete Elastomer kann - je nach Anwendungsfall - auch mit keramischen Partikeln versetzt sein.

Das Elastomer-Pad 18 ist an einem Ende einer Blattfeder 17 befestigt, die mit ihrem gegenüberliegenden Ende gelenkig an dem Prüfsockel 1 montiert ist. Da hier eine Vielzahl von Befestigungen möglich ist, ist die gelenkige Befestigung in der Zeichnung nicht dargestellt. In der in Fig. 4a gezeigten Ruhestellung liegt die Blattfeder 17 an der Unterseite des Prüfsockels 1 an und drückt so das an einer Seite befestigte Elastomer-Pad 18 von unten an den Prüfkontakt 2. Da sich die Spitze des Prüfkontakts 2 in die Oberfläche des Elastomer-Pads 18 eindrückt entsteht so eine etwa keilförmige Vertiefung in der Oberfläche des Elastomer-Pads 18.

In die Unterseite des Prüfsockel 1 ist eine Konturmulde 19 eingearbeitet, die durch die Blattfeder 18 teilweise abgedeckt wird. An dem Nest 3 oder dem Druckstempel 13 ist ein der Konturmulde 19 entsprechender Konturstempel 20 befestigt. Die Oberseite des Konturstempels 20 ist an die Kontur der Konturmulde 19 angepasst.

Bewegt sich nun das Nest 3 zusammen mit dem Konturstempel 20 nach oben, berührt der Konturstempel 20 die Blattfeder 17 bevor die Bauteilkontakte 5 in die Reichweite der Spitzen der Prüfkontakte 2 gelangen. Bei der weiteren Bewegung des Konturstempels 20 drückt dieser die Blattfeder 17 in die Konturmulde 19. Dabei hebt das Elastomer-Pad 18 von der Spitze des Prüfkontakts 2 ab und bewegt sich in die in Fig. 4b gezeigte Stellung. Das Elastomer-Pad erhält seine ursprüngliche Form, ohne die durch den Prüfkontakt verursachte keilförmige Vertiefung.

Form und Größe von Konturstempel 20 und Konturmulde 19 können entweder so angepasst sein, dass nach dem Abheben des Elastomer-Pads 18 die Bauteilkontakte 5 auf die Prüfkontakte 2 aufsetzen, noch bevor der Konturstempel 20 den Boden der Konturmulde 19 erreicht hat. Eine weitere Möglichkeit besteht darin, den Konturstempel 20 federbelastet an die Bewegung des Nests 3 zu koppeln, so dass sich das Nest 3 auch dann noch in seine Prüfstellung bewegen kann, wenn der Konturstempel 20 bereits vollkommen in die Konturmulde 19 eingetaucht ist und aus diesem Grund keine weitere Aufwärtsbewegung des Konturstempels 20 mehr möglich ist.

Mit einem solchen Kulissenantrieb sind aber auch noch andere Ausführungen möglich. So könnte beispielsweise die Blattfeder an der linken Seite des in Fig. 4 gezeigten Prüfsockels linear geführt sein. Beim Eintauchen des Konturstempels in die Konturmulde würde sich dann das Elastomer-Pad lediglich um eine bestimmte Strecke nach rechts verschieben und so den Prüfkontakt freigeben.

### Bezugszeichenliste:

- 1: Prüfsockel
- 2: Prüfkontakte
- 3: Nest
- 4: elektronisches Bauteil
- 5: Bauteilkontakte
- 6: linker Grundkörper
- 7: linkes Kontaktmodul
- 8: rechter Grundkörper
- 9: rechtes Kontaktmodul
- 10: einteiliger Grundkörper
- 11: Federelement
- 12: Halteglied
- 13: Druckstempel
- 14: Gewindestangen
- 15: Loadboard
- 16: Test-Kopf
- 17: Blattfeder
- 18: Elastomer-Pad
- 19: Konturmulde
- 20: Konturstempel

## Patentansprüche

1. Vorrichtung zum Prüfen von elektronischen Bauteilen (4) mit wenigstens einem Prüfsockel (1) mit Prüfkontakten (2), mit einem Nest (3), in dem wenigstens ein elektronisches Bauteil (4) platzierbar ist und mit wenigstens einer Reinigungseinheit (6, 7; 8, 9; 10, 7, 9) für die Prüfkontakte (2) des Prüfsockels (1), wobei das elektronische Bauteil (4) durch eine als Prüfhub ausführbare Relativbewegung zwischen Prüfsockel (1) und Nest (3) an die Prüfkontakte (2) des Prüfsockels (1) andrückbar und wieder von diesen abhebbar ist, **dadurch gekennzeichnet, dass** die wenigstens eine Reinigungseinheit (6, 7; 8, 9; 10, 7, 9) so ausgestaltet ist, dass die Prüfkontakte (2) bei jedem Prüfhub mit der wenigstens einen Reinigungseinheit (6, 7; 8, 9; 10, 7, 9) in Kontakt kommen.

2. Vorrichtung nach Anspruch 1, **dadurch gekennzeichnet, dass** die wenigstens eine Reinigungseinheit (6, 7; 8, 9; 10, 7, 9) so montiert ist, dass sie sich zusammen mit dem Nest (3) bewegt.

3. Vorrichtung nach Anspruch 2, **dadurch gekennzeichnet, dass** die wenigstens eine Reinigungseinheit (6, 7; 8, 9) an dem Nest (3) oder an einem das Nest (3) bewegendem Stempel montiert ist.

4. Vorrichtung nach Anspruch 2, **dadurch gekennzeichnet, dass** das elektronische Bauteil (4) durch ein Halteglied (12) in dem Nest (3) fixiert ist und dass die wenigstens eine Reinigungseinheit (10, 7, 9) an dem Halteglied (12) befestigt ist.

5. Vorrichtung nach Anspruch 1, **dadurch gekennzeichnet, dass** die wenigstens eine Reinigungseineinheit (10, 7, 9) beweglich an dem Prüfsockel (3) befestigt ist.

6. Vorrichtung nach Anspruch 5, **dadurch gekennzeichnet, dass** die wenigstens eine Reinigungseinheit (10, 7, 9) entgegen der Kraft eines elastischen Elements (11) gegen den Prüfsockel (3) beweglich ist.

7. Vorrichtung nach einem der Ansprüche 5 bis 6, **dadurch gekennzeichnet, dass** die wenigstens eine Reinigungseinheit (10, 7, 9) durch das Nest (3) oder durch mit dem Nest (3) gekoppelte Teile (4) bewegt wird.

8. Vorrichtung nach einem der Ansprüche 1 bis 7, **dadurch gekennzeichnet, dass** die wenigstens eine Reinigungseinheit (6, 7; 8, 9; 10, 7, 9) einen Grundkörper (6; 8; 10) und wenigstens ein Kontaktmodul (7; 9; 7, 9) aufweist.

9. Vorrichtung nach Anspruch 8, **dadurch gekennzeichnet, dass** das wenigstens eine Kontaktmodul (7; 9; 7, 9) Borsten aufweist.

10. Vorrichtung nach Anspruch 8, **dadurch gekennzeichnet, dass** das wenigstens eine Kontaktmodul (7; 9; 7, 9) aus einem elastischen Kunststoff besteht, wobei eine die Prüfkontakte (2) reinigende Oberfläche des wenigstens einen Kontaktmoduls (7; 9; 7, 9) eine vorbestimmte Rauigkeit aufweist.

11. Vorrichtung nach einem der Ansprüche 1 bis 10, **dadurch gekennzeichnet, dass** die wenigstens eine Reinigungseineinheit (6, 7; 8, 9; 10, 7, 9) auswechselbar ist.

12. Vorrichtung nach einem der Ansprüche 8 bis 11, **dadurch gekennzeichnet, dass** das wenigstens eine Kontaktmodul (7; 9; 7, 9) auswechselbar ist.
